(19) Europäisches Patentamt / European Patent Office / Office européen des brevets

(11) **EP 3 077 834 B1**

(12) **FASCICULE DE BREVET EUROPEEN**

(45) Date de publication et mention de la délivrance du brevet:
**11.04.2018 Bulletin 2018/15**

(51) Int Cl.:
***G01R 31/00*** *(2006.01)*    ***G01R 27/18*** *(2006.01)*
***G01R 31/02*** *(2006.01)*

(21) Numéro de dépôt: **14821774.8**

(22) Date de dépôt: **02.12.2014**

(86) Numéro de dépôt international:
**PCT/FR2014/053115**

(87) Numéro de publication internationale:
**WO 2015/082825 (11.06.2015 Gazette 2015/23)**

(54) **ESTIMATION DE LA RESISTANCE D'ISOLEMENT ENTRE UNE BATTERIE DE VEHICULE AUTOMOBILE ET LA MASSE**

SCHÄTZUNG DES ISOLATIONSWIDERSTANDS ZWISCHEN EINER KRAFTFAHRZEUGBATTERIE UND DER ERDE

ESTIMATION OF THE INSULATION RESISTANCE BETWEEN A MOTOR VEHICLE BATTERY AND THE EARTH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.12.2013 FR 1362092**

(43) Date de publication de la demande:
**12.10.2016 Bulletin 2016/41**

(73) Titulaire: **Renault S.A.S.**
**92100 Boulogne-Billancourt (FR)**

(72) Inventeurs:
• **MENSLER, Michel**
  **F-78180 Montigny le Bretonneux (FR)**
• **MERIENNE, Ludovic**
  **F-91190 Gif sur Yvette (FR)**

(56) Documents cités:
DE-A1-102010 006 108    FR-A1- 2 987 133
JP-A- 2003 250 201    US-A1- 2010 244 850

• **JINGXIN LI ET AL: "Research on Insulation Resistance On-Line Monitoring for Electric Vehicle", ELECTRICAL MACHINES AND SYSTEMS, 2005. ICEMS 2005. PROCEEDINGS OF THE EIGHTH INTERNATIONAL CONFERENCE ON NANJING, CHINA 27-29 SEPT. 2005, PISCATAWAY, NJ, USA,IEEE, vol. 1, 27 septembre 2005 (2005-09-27), pages 814-817, XP010877521, ISBN: 978-7-5062-7407-4**

**Description**

L'invention concerne l'estimation de la résistance d'isolement entre un point d'un circuit haute tension et une masse. En particulier, l'invention peut concerner la détection de défauts d'isolement entre n'importe quel point d'un circuit haute-tension comprenant une batterie haute-tension d'un véhicule automobile et la masse de ce véhicule.

La batterie haute tension du véhicule automobile peut être une batterie de traction de véhicule.

Le véhicule peut être un véhicule électrique ou hybride.

Il est important de mesurer la résistance d'isolement entre les points du circuit haute-tension et la masse du véhicule afin de prévenir tout choc électrique pour les passagers du véhicule, ou toute personne entrant en contact avec le véhicule. En particulier, cette détection peut permettre de corriger un premier défaut d'isolement avant qu'un deuxième défaut d'isolement ne survienne. Un double défaut peut en effet créer un court-circuit, lequel est susceptible de provoquer une panne du véhicule.

Il est connu de mesurer cette résistance d'isolement en utilisant un circuit de mesure discret. Par exemple, le document JP3783633 décrit un circuit de mesure de la résistance d'isolement relativement simple. On peut ainsi déduire une valeur de résistance d'isolement à partir d'une seule valeur de tension mesurée, mais cette estimation est effectuée en supposant qu'une valeur de capacité entre le circuit de mesure et la batterie est parfaitement connue. Or, la valeur de cette capacité est susceptible de varier, en fonction de divers paramètres comme par exemple la température ou le vieillissement. Un tel procédé peut donc manquer de robustesse.

Le document FR2987133 décrit un procédé plus robuste, basé sur des identifications de paramètres, dans lequel on mesure plusieurs valeurs d'un signal de tension aux bornes d'un circuit de mesure, et dans lequel on déduit de cet ensemble de valeurs à la fois une valeur de capacité entre le circuit de mesure et la batterie, et une valeur de résistance d'isolement. Néanmoins, les calculs effectués sont relativement élaborés et le temps de calcul peut être relativement long du fait du nombre de valeurs mesurées nécessaires.

Il existe donc un besoin pour une estimation permettant de concilier simplicité et robustesse.

Il est proposé un procédé de d'estimation de la résistance d'isolement entre un point d'un circuit haute-tension, en particulier une borne d'une batterie de véhicule automobile, par exemple une batterie haute tension d'un véhicule électrique ou hybride, et une masse, par exemple la masse de ce véhicule. Ce procédé comprend :

(a) mesurer ou recevoir une valeur de tension mesurée aux bornes d'un circuit de mesure, ledit circuit de mesure comprenant un élément capacitif raccordé au circuit haute tension, par exemple à la batterie,
(b) calculer une valeur d'écart courante en fonction de la valeur de tension mesurée, et en fonction d'une valeur de tension théorique estimée à partir d'une modélisation du circuit de mesure, ladite modélisation étant fonction d'une valeur de capacité de l'élément capacitif,
(c) calculer une valeur d'écart moyenné, à partir de la valeur d'écart courante et d'une pluralité de valeurs d'écart précédentes, et
(d) estimer une valeur de résistance d'isolement actualisée en fonction de ladite valeur d'écart moyenné.

Un tel procédé s'est avéré relativement robuste par rapport aux variations éventuelles de la valeur de capacité de l'élément capacitif.

En effet, cette valeur de capacité peut avoir une influence sur les variations au cours du temps des valeurs de tension mesurées. La valeur d'écart moyenné est ainsi relativement peu affectée par les variations éventuelles de la valeur de capacité de l'élément capacitif. Dit autrement, on met en place un régulateur pour s'affranchir des variations liées à l'imprécision quant à la valeur de capacité de l'élément capacitif.

Avantageusement et de façon non limitative, le procédé peut comprendre en outre une étape de génération d'un signal d'alarme, selon la valeur de résistance d'isolement actualisée à l'étape (d), pour prévenir de la détection d'un défaut d'isolement.

La modélisation peut avantageusement être fonction en outre d'une valeur précédente de résistance d'isolement entre le circuit haute-tension et la masse.

Avantageusement et de façon non limitative, les étapes (a), (b), (c), (d) peuvent être réitérées régulièrement.

Avantageusement et de façon non limitative, au moins une, et de préférence chaque, valeur d'écart peut être estimée à partir d'une valeur de tension mesurée et à partir d'une valeur de tension théorique correspondant à une même itération.

Avantageusement et de façon non limitative, la valeur de résistance d'isolation actualisée au cours d'une itération courante peut être choisie comme valeur de résistance d'isolation précédente à l'itération suivante.

Avantageusement et de façon non limitative, la valeur de capacité de l'élément capacitif utilisée pour modéliser le circuit de mesure peut être choisie égale à une valeur constante sur plusieurs itérations, par exemple sur un nombre d'itérations prédéterminé ou bien encore tout au long de l'exécution du procédé.

On pourrait alternativement prévoir d'actualiser cette valeur de capacité, par exemple à chaque itération, ou cycle, en fonction de la valeur de résistance d'isolement actualisée et en fonction de la valeur de tension mesurée en sortie du circuit de mesure.

Avantageusement et de façon non limitative, au cours de l'étape (c) la valeur d'écart courante peut être calculée en prenant la différence entre la valeur théorique et la valeur mesurée, ou inversement. Alternativement, on pourrait bien entendu prévoir de calculer un ratio entre valeurs mesurées et théorique, ou autre.

Avantageusement et de façon non limitative, au cours de l'étape (c) de calcul de la valeur d'écart, on multiplie la différence par +1 ou -1 en fonction de la valeur d'un signal d'entrée du circuit de mesure.

Ainsi, on peut mettre en place un régulateur avec en entrée une différence entre une mesure et une estimation issue d'un modèle, pondérée par un signe dépendant de la valeur du signal à l'entrée du circuit de mesure.

En particulier, cette pondération peut valoir 1 lorsque le signal d'entrée est haut, c'est-à-dire pour un créneau montant, et valoir -1 dans le cas d'un créneau descendant, c'est-à-dire lorsque lorsque le signal d'entrée est bas.

Avantageusement et de façon non limitative, la valeur d'écart moyenné peut être obtenue en ajoutant à la valeur d'écart courante une valeur d'écart moyenné précédente. Cette valeur d'écart moyenné précédente peut avantageusement être elle-même une somme, par exemple une somme discrète ou une intégrale. Ainsi, plutôt que de conserver en mémoire l'ensemble des valeurs d'écart précédentes, on peut se contenter de stocker simplement la valeur d'écart moyenné précédente.

L'invention n'est en rien limitée à cette utilisation de la valeur d'écart moyenné précédente, ni même au choix d'une somme de valeurs d'écarts. On pourrait par exemple prévoir de calculer une combinaison linéaire des valeurs d'écart précédentes et courante, ou bien encore une moyenne géométrique, une médiane, une moyenne quadratique, ou autre.

Avantageusement et de façon non limitative, l'étape (e) d'estimation de la valeur de résistance d'isolement actualisée peut être fonction d'une combinaison linéaire de la valeur d'écart courante et de la valeur d'écart moyenné courante.

Avantageusement et de façon non limitative, la valeur de résistance d'isolement actualisée peut ainsi être estimée suivant la formule :

$$R_{isol}(n) = K_{variable}\left[R_{isol}(n-1)\right]\left(K_p \varepsilon + K_i \int \varepsilon\right)$$

dans lequel n correspond à l'itération courante, (n-1) correspondant à l'itération immédiatement précédente,

$R_{isol}(n)$ représente la valeur de résistance d'isolement actualisée pour cette itération,

$R_{isol}(n-1)$ est la valeur de résistance actualisée à l'itération précédente,

$\varepsilon$ est une valeur d'écart entre des valeurs théoriques et mesurées de tension, cette valeur d'écart étant obtenue en pondérant par +1 ou - 1, en fonction du signal à l'entrée du circuit de mesure, une valeur de différence entre les valeurs théoriques et mesurées,

$K_i$ et $K_p$ sont des constantes prédéterminées, et

$K_{variable}$ est une valeur de paramètre sans dimension.

Avantageusement et de façon non limitative, la formule utilisée pour estimer la valeur courante de la résistance d'isolement peut être fonction de la valeur de résistance d'isolement précédente.

Ainsi, ce paramètre $K_{variable}$ peut être lui-même fonction de la valeur de la résistance d'isolement précédente.

Ainsi, on peut par exemple définir une table de gains en fonction de la valeur de résistance d'isolement. Ces valeurs du paramètre $K_{variable}$ peuvent être définies en fonction de contraintes extérieures comme le temps de détection maximal autorisé pour calculer et délivrer une valeur de résistance d'isolement. Ceci peut permettre de converger plus rapidement vers une valeur de résistance d'isolement relativement stable.

Ainsi, le circuit de mesure peut faire l'objet d'une modélisation, cette modélisation étant utilisée pour estimer les valeurs théoriques du signal à partir d'une valeur précédentes de la résistance d'isolement et à partir de valeurs supposées connues des différents composants du circuit de mesure.

Dans un mode de réalisation avantageux, l'écart entre les valeurs théoriques et mesurées peut être pondéré par un signe fonction de la valeur du signal à l'entrée du circuit de mesure, puis un régulateur proportionnel intégral peut permettre d'estimer une valeur courante de la résistance d'isolement en fonction de cet écart et d'une moyenne des écarts obtenus au cours du temps. Une fois la résistance d'isolement ainsi actualisée, le modèle numérique du circuit peut être actualisé à son tour.

Ce procédé peut comprendre en outre une étape consistant à transmettre vers une interface utilisateur le signal d'alarme élaboré en fonction de la valeur de la résistance d'isolement actualisée.

Ainsi, ce procédé peut permettre de détecter les défauts d'isolement plus rapidement que décrit dans le document FR2987133, et ce, tout en s'affranchissant des erreurs liées à la précision quant à la valeur de l'élément capacitif.

Il est en outre proposé un produit programme d'ordinateur comprenant des instructions pour effectuer les étapes du procédé décrit ci-dessus lorsque ces instructions sont exécutées par un processeur. Ce programme peut par exemple être stocké sur un support mémoire de type disque dur, téléchargé, ou autre.

Il est en outre proposé un dispositif d'estimation de la résistance d'isolement entre un point d'un circuit haute-tension comprenant une batterie haute tension de véhicule automobile et la masse du véhicule, comprenant :

- des moyens de réception pour recevoir une valeur de tension mesurée aux bornes d'un circuit de mesure, ledit circuit de mesure comprenant un élément capacitif raccordé à la batterie,
- une mémoire pour stocker une modélisation du circuit de mesure, ladite modélisation étant fonction d'une valeur de capacité de l'élément capacitif, et
- des moyens de traitement agencés pour calculer une valeur d'écart courante en fonction de la valeur de tension mesurée et en fonction d'une valeur de tension théorique estimée à partir de la modélisation du circuit de mesure, pour calculer une valeur d'écart moyenné à partir de la valeur d'écart courante et d'une pluralité de valeurs d'écart précédentes, et pour estimer une valeur de résistance d'isolement actualisée en fonction de ladite valeur d'écart moyenné.

Le dispositif, par exemple un processeur de type microprocesseur, microcontrôleur ou autre, peut permettre de mettre en oeuvre le procédé décrit ci-dessus.

Le dispositif peut avantageusement comprendre en outre des moyens de transmission pour transmettre un signal d'alarme élaboré en fonction de la valeur de résistance d'isolement estimée par les moyens de traitement, afin de signaler la détection d'un défaut d'isolement le cas échéant. Le dispositif peut alors être un dispositif de détection des défauts d'isolement.

Néanmoins, l'invention n'est en rien limitée à cette application à la détection des défauts d'isolement.

Les moyens de réception peuvent par exemple comprendre une broche d'entrée, un port d'entrée ou autre.

La mémoire peut être une mémoire vive ou RAM (de l'anglais « Random Access Memory »), une EEPROM (de l'anglais « (Electrically-Erasable Programmable Read-Only Memory »), ou autre.

Les moyens de traitement peuvent par exemple un coeur de processeur ou CPU (de l'anglais « Central Processing Unit »).

Les moyens de transmission peuvent par exemple comprendre une broche de sortie, un port de sortie, ou autre.

Il est en outre proposé un système d'estimation de la résistance d'isolement entre un point d'un circuit haute-tension et une masse, par exemple un système de détection de défaut d'isolement entre un point d'un circuit haute-tension et une masse, ce système comprenant un circuit de mesure raccordé au circuit haute tension, par exemple à une batterie, par un composant capacitif, et un dispositif d'estimation tel que décrit ci-dessus, ce dispositif d'estimation étant raccordé électriquement à une entrée du circuit de mesure, et à une borne de mesure du circuit de mesure afin de mesurer les valeurs de tension.

Le circuit de mesure peut être de conception relativement simple, avec par exemple une résistance d'entrée dont une borne est raccordée électriquement à l'entrée du circuit de mesure, et une partie de filtrage passe-bas comprenant un élément résistif et un élément capacitif.

Il est en outre proposé un véhicule automobile, par exemple un véhicule électrique ou hybride, comprenant une batterie apte à faire rouler les roues avant et/ou les roues arrière, et un système tel que décrit ci-dessus.

L'invention sera mieux comprise en référence aux figures, lesquelles illustrent de modes de réalisation non limitatifs et donnés à titre d'exemple.

La figure 1 montre un exemple de système d'estimation de résistance d'isolement, ici un système de détection de défaut d'isolement, selon un mode de réalisation de l'invention.

La figure 2 représente schématiquement un exemple de dispositif de détection selon un mode de réalisation de l'invention.

La figure 3A est un graphique montrant l'évolution au cours du temps d'un signal de tension théorique et d'un signal de tension mesuré, lors de l'application d'un exemple de procédé selon un mode de réalisation de l'invention.

La figure 3B est un graphique, correspondant au graphique de la figure 3A, montrant l'évolution au cours du temps de la valeur de résistance d'isolement estimée lors de l'application de ce procédé.

Des références identiques peuvent être utilisées d'une figure à l'autre pour désigner des éléments identiques ou similaires, dans leur forme ou dans leur fonction.

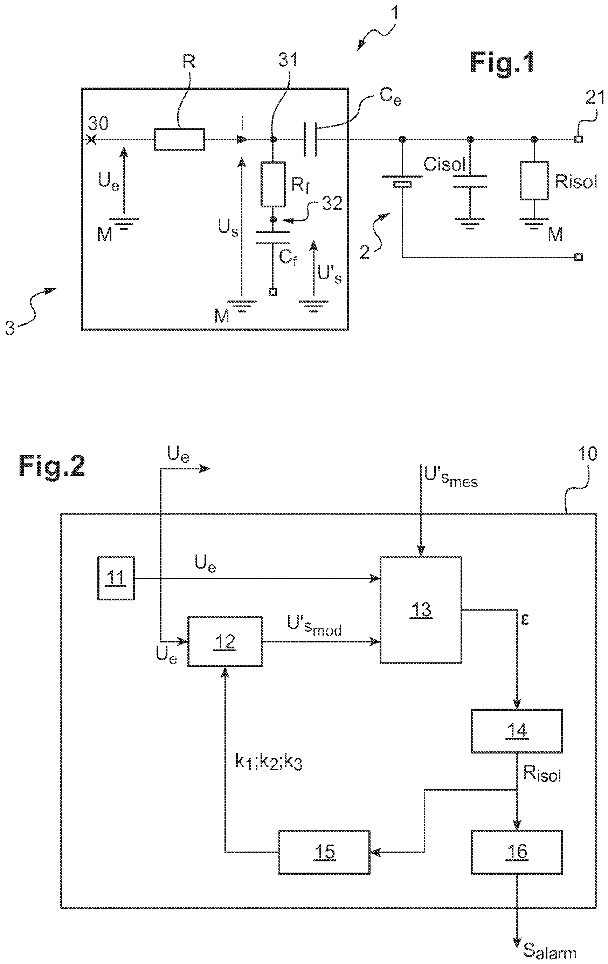

En référence à la figure 1, est représenté un système de détection 1 de défaut d'isolement entre une borne 21 d'un circuit haute tension, ici une batterie haute tension 2 d'un véhicule automobile, et la masse M de ce véhicule automobile.

Ce système de détection 1 comprend un circuit de mesure 3 et un dispositif de détection non représenté sur la figure 1, par exemple un processeur.

La batterie 2 est utilisée pour faire tourner les roues avant et/ou les roues arrière d'un véhicule électrique ou hybride. Un freinage régénératif peut être mis en oeuvre, c'est-à-dire que lorsque le conducteur impose une consigne de freinage, de l'énergie peut être récupérée et stockée dans la batterie 2.

Le circuit de mesure 3 comprend une résistance d'entrée R entre une borne d'entrée 30 et une borne de rattachement à la batterie 31. Le circuit de mesure 3 comprend en outre, entre la borne de rattachement 31 et la masse une résistance $R_f$ et une capacité $C_f$. Une tension de sortie $U'_s$ est mesurée à un point de mesure 32 entre la résistance $R_f$ et la capacité $C_f$. Les composants $R_f$ et $C_f$ jouent ici un rôle de filtre passe-bas.

Une tension d'entrée $U_e$ est commandée par le processeur et une mesure de la tension de sortie $U'_s$, ou $U'_{Smes}$, est reçue par ce processeur.

Le circuit de mesure 3 comprend un élément capacitif $C_e$ entre la batterie 2 et le reste du circuit de mesure.

Sur la figure 1 la capacité Cisol et la résistance Risol représentent la capacité équivalente et la résistance équivalente, respectivement, entre la borne 21 de la batterie haute tension 2 et la masse.

On cherche à estimer la valeur de cette résistance d'isolement Risol afin de déclencher une alarme lorsque cette résistance est trop faible.

Le signal d'entrée $U_e$ appliqué entre la borne 30 et la masse peut être du type échelon carré avec une fréquence $f_e$.

Ce signal peut être généré relativement facilement par le processeur, par exemple un microprocesseur d'un module BMS.

Les valeurs des éléments de filtrage passe-bas $R_f$ et $C_f$ sont connues et relativement peu variables dans le temps.

La valeur de la résistance d'entrée R est également connue.

En revanche, la valeur de l'élément capacitif $C_e$ est susceptible de varier, avec des variations de l'ordre de 30% par rapport à la valeur initiale, au cours de la durée de vie du véhicule. Et bien entendu, la valeur de la résistance d'isolement Risol peut varier notamment en cas de défaut d'isolement. La valeur de cette résistance d'isolement est ainsi susceptible de passer de quelque MOhms à seulement quelques kOhms.

La fonction de transfert entre la tension de sortie et le signal d'entrée peut s'écrire :

$$\frac{U'_s}{U_e} = \frac{1 + Risol\,C_e\,s}{1 + \left[C_e(Risol + R) + C_f(R_f + R)\right]s + \left[C_e C_f\left(RR_f + Risol(R + R_f)\right)\right]s^2}$$

dans laquelle s est la variable de Laplace.

Il est connu d'estimer à la fois la valeur de la résistance d'isolement Risol et la valeur de capacité de l'élément capacitif $C_e$, en utilisant un relativement grand nombre de points de mesure. De ce fait, la valeur de la résistance d'isolement est actualisée après un temps relativement long. Par exemple, pour une fréquence $f_e$ du signal d'entrée $U_e$ de l'ordre de 2 Hz, la fréquence d'acquisition du signal de sortie $U'_s$ étant de l'ordre de 100 Hz, si le procédé requiert 100 points de mesure pour pouvoir produire une valeur correcte, il faudra attendre deux périodes, soit une seconde pour pouvoir mettre à jour la valeur de la résistance d'isolement.

La présente invention peut permettre une actualisation plus rapide et en particulier à chaque mesure, c'est-à-dire toutes les 10 ms par exemple, et ce, tout en assurant une convergence de l'estimation indépendamment de la capacité $C_e$.

On prévoit un modèle discret du circuit de mesure. En utilisant une transformée bilinéaire, à partir de l'équation ci-dessus, il est possible de calculer une transformée en z de circuit correspondant à une période d'échantillonnage Te, par exemple 10 ms. En posant $\dfrac{U'_s}{U_e} = \dfrac{1 + k_1 s}{1 + k_2 s + k_3 s^2}$ et $s = \dfrac{2}{T_e}\dfrac{1 - z^{-1}}{1 + z^{-1}}$ , on obtient :

$$\frac{U'_s}{U_e} = \frac{1 + \dfrac{2k_1}{T_e} + 2z^{-1} + \left(1 - \dfrac{2k_1}{T_e}\right)z^{-2}}{1 + \dfrac{2k_2}{T_e} + \dfrac{4k_3}{T_e^2} + \left(2 - \dfrac{8k_3}{T_e^2}\right)z^{-1} + \left(1 + \dfrac{2k_2}{T_e} + \dfrac{4k_3}{T_e^2}\right)z^{-2}}$$

dans lequel les paramètres $k_1$, $k_2$, $k_3$ dépendent des paramètres du circuit de mesure et en particulier de la valeur de la résistance d'isolement selon

$$k_1 = Risol\,C_e,$$

$$k_2 = C_e(Risol + R) + C_f(R_f + R),$$

et

$$k_3 = C_e C_f(RR_f + Risol(R + R_f))$$

Ce modèle permet de simuler la réponse du circuit de mesure.

La figure 2 représente schématiquement un exemple de dispositif de détection 10 de défaut d'isolement entre la batterie de traction référencée 2 sur la figure 1 et la masse.

Ce dispositif comporte un module 11 de génération d'un signal d'entrée $U_e$. Ce signal est envoyé vers la borne 30 du circuit de mesure et est également reçu à l'entrée d'un module de modélisation numérique du circuit de mesure 12. Ce module 12 estime, en utilisant les équations ci-dessus, et notamment les valeurs de paramètres $k_1$, $k_2$, $k_3$ courantes, une valeur théorique du signal de sortie $U'_{Smod}$.

Cette valeur $U'_{Smod}$ est reçue par un module d'estimation d'écart pondéré 13. Ce module 13 reçoit en outre une valeur mesurée de signal de sortie $U'_{Smes}$ c'est-à-dire une valeur de tension mesurée à la borne 32 du circuit de mesure 3 de la figure 1.

Le module 13 calcule une différence entre ces deux valeurs $U'_{Smes}$ et $U'_{Smod}$. Le signe de cette différence est en fonction de la valeur du signal d'entrée $U_e$.

En effet, comme il ressort de la figure 2, les paramètres $k_1$, $k_2$, $k_3$ sont régulièrement remis à jour de sorte que le modèle du circuit de mesure est régulièrement réactualisé. Ainsi, le modèle utilisé par le module 12 varie en fonction de la valeur de la résistance d'isolement estimée.

On estime la valeur de cette résistance d'isolement en recherchant les valeurs qui tendent à minimiser l'écart $\varepsilon$ entre la réponse du circuit physique $U'_{Smes}$ et la sortie $U'_{Smod}$ du modèle simulant le circuit. Un régulateur 14 permet d'estimer des valeurs de la résistance d'isolement $R_{isol}$ actualisées afin de faire converger la sortie du modèle $U'_{Smod}$ avec la mesure $U'_{Smes}$. On met à jour la valeur de la résistance d'isolement estimée $R_{isol}$ à chaque pas de calcul.

Plus la valeur de la résistance d'isolement est élevée, plus la réponse du circuit à l'excitation comme signal d'entrée sera rapide. Dans le cas d'une réponse du circuit de mesure à un créneau montant de 5 Volts, c'est-à-dire lorsque le signal d'entrée $U_e$ passe de 0 à 5 Volts, si la sortie du modèle $U'_{Smod}$ est supérieure à la valeur mesurée $U'_{Smes}$ c'est-à-dire si le modèle est plus rapide que la mesure, alors le module 14 tend à diminuer la valeur de la résistance d'isolement estimée, c'est-à-dire que le modèle est ralenti.

Inversement, si la valeur de sortie du modèle $U'_{Smod}$ a une valeur inférieure à une valeur mesurée $U'_{Smes}$, c'est-à-dire si le modèle est plus lent que la mesure, alors le module 14 tend à augmenter la valeur de la résistance $R_{isol}$ estimée.

Dans le cas d'un créneau descendant, c'est-à-dire lorsque le signal d'entrée passe de 5 Volts à 0 Volt, on applique le raisonnement inverse. Ainsi, si la sortie du modèle $U'_{Smod}$ a une valeur supérieure à la valeur mesurée $U'_{Smes}$, c'est-à dire que le modèle est plus lent que le circuit physique réel, alors la valeur de la résistance d'isolement est augmentée, et inversement dans le cas contraire.

Ainsi le module 14 peut être un régulateur de type proportionnel-intégral avec en entrée une différence $\varepsilon$ entre la valeur mesurée $U'_{Smes}$ et la valeur théorique $U'_{Smod}$ pondérée par un signe dépendant de la valeur du signal d'entrée $U_e$. Cette pondération vaudra +1 lorsque le signal d'entrée vaut 5 Volts, c'est-à-dire dans le cas d'un créneau montant, et vaudra -1 lorsque le signal d'entrée vaut 0 Volt, c'est à dire dans le cas d'un créneau descendant.

Pour revenir au modèle mis en oeuvre dans le module 12, en notant n l'instant courant, n-1 l'instant précédent, et n-2 l'instant précédent encore, ce module 12 peut mettre en oeuvre la formule suivante :

$$U'_{S\,mod}(n) = \frac{\left(1 + \frac{2k_1}{T_e}\right)U_e(n) + 2U_e(n-1)}{1 + \frac{2k_2}{T_e} + \frac{4k_3}{T_e^2}}$$

$$+ \frac{\left(1 - \frac{2k_1}{T_e}\right)U_e(n-2) + \left(\frac{8k_3}{T_e^2} - 2\right)U'_{S\,mod}(n-1)}{1 + \frac{2k_2}{T_e} + \frac{4k_3}{T_e^2}}$$

$$- \frac{\left(1 + \frac{2k_2}{T_e} + \frac{4k_3}{T_e^2}\right)U'_{S\,mod}(n-2)}{1 + \frac{2k_2}{T_e} + \frac{4k_3}{T_e^2}}$$

$T_e$ étant la période du signal d'entrée $U_e$.

Le régulateur proportionnel intégral 14 peut être réglé en fonction du besoin et du compromis entre rapidité et précision que l'on souhaite avoir sur l'estimation.

Comme la plage de valeurs de résistance d'isolement peut être très large, de quelques Ohms à quelques MOhms, on peut également prévoir un gain variable en fonction de la valeur de résistance d'isolement estimée. Si cette valeur est relativement élevée, de l'ordre de plusieurs centaines de KOhms ou du MOhms, le besoin de précision est moindre mais on sera en revanche intéressé par une solution rapide. Au contraire pour une valeur de résistance d'isolement relativement faible, de l'ordre de la dizaine de kOhms ou moins, il convient d'avoir une meilleure précision car cette valeur représente un seuil de dangerosité.

On peut donc définir une table de gains en fonction de la valeur de la résistance d'isolement estimée. Des valeurs $K_{variable}$ peuvent être définies en fonction de contraintes extérieures comme le temps de détection maximal autorisé pour calculer et délivrer la valeur de la résistance d'isolement.

Le module 14 peut ainsi mettre en oeuvre la formule suivante :

$$R_{isol}(n) = K_{variable}\left[R_{isol}(n-1)\right]\left(K_p\varepsilon + K_i\int\varepsilon\right)$$

dans lequel $K_i$ et $K_p$ sont des gains réglés hors ligne par des méthodes classiques de réglages de correcteurs proportionnels intégrales basées sur une valeur de résistance d'isolation arbitraire. Ces valeurs de paramètre $K_p$, $K_i$ sont ainsi prédéterminées.

Une fois l'estimation de la résistance d'isolement actualisée, un module 15 permet de mettre à jour les valeurs des paramètres $k_1$, $k_2$, $k_3$ en utilisant la formule ci-dessus dans lesquelles la valeur de la capacité $C_e$ peut être choisie de façon arbitraire avec une précision de plus ou moins 50% par rapport réelle. On peut utiliser la valeur initiale de cette capacité tout au long du procédé, ou au moins pendant un certain nombre de cycles.

Une fois ces paramètres mis à jour, il est possible de calculer une nouvelle sortie du modèle lorsque basé sur cette nouvelle actualisation de l'estimation de la résistance d'isolement. Par ailleurs, un module 16 permet de générer un signal d'alarme $S_{alarm}$ à partir de la valeur de résistance d'isolement issue du modèle 14. Ce module 16 peut par exemple comparer la valeur de la résistance d'isolement à un seuil et déclencher une alarme lorsque la valeur de la résistance d'isolement est inférieure à ce seuil.

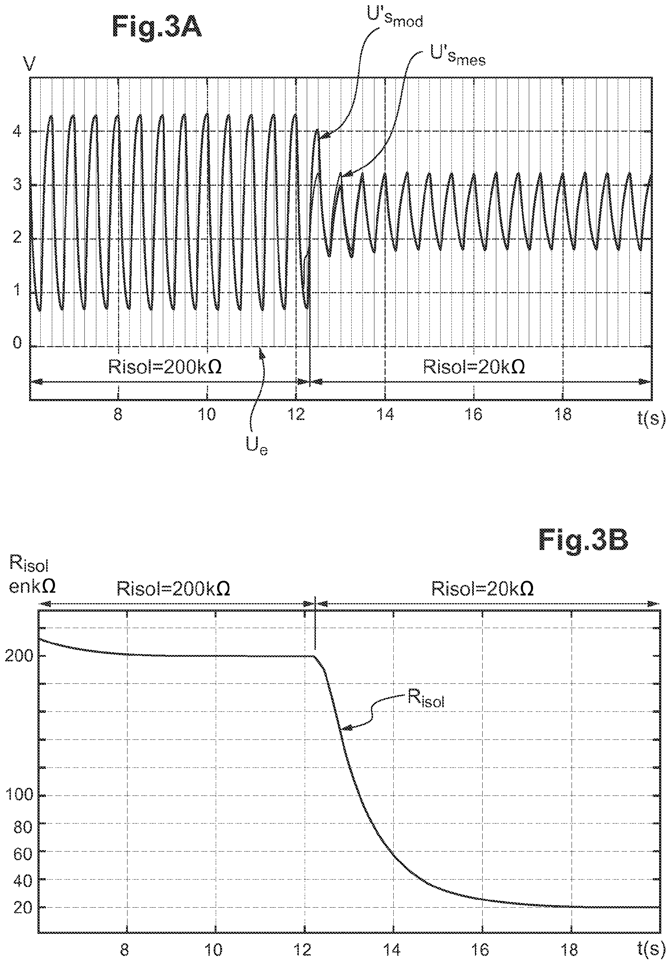

En référence à la figure 3A, le signal $U'_{Smod}$ est représenté en fonction du temps ainsi que le signal $U'_{Smes}$. On suppose que quelques instants après t=12 secondes, le véhicule connaît un défaut d'isolement et la valeur de la résistance d'isolation chute de 200 kOhms à 20 kOhms. Cette simulation représente un cas d'apparition de défaut d'isolement. Il ressort que le temps de réponse est inférieur à 5 secondes.

Comme le montre la figure 3B, la valeur de la résistance d'isolement calculée par le régulateur proportionnel intégral 14 chute très rapidement et converge vers la valeur réelle.

L'invention permet ainsi de détecter les défauts d'isolement de façon simple et robuste du fait de la tolérance aux variations de la valeur de la capacité $C_e$.

**Revendications**

1. Procédé d'estimation de la résistance d'isolement entre un point d'un circuit haute-tension comprenant une batterie haute tension de véhicule automobile et la masse dudit véhicule, comprenant :

   (a) mesurer une valeur de tension ($U'_{Smes}$) aux bornes d'un circuit de mesure, ledit circuit de mesure comprenant un élément capacitif raccordé à la batterie,
   (b) calculer une valeur d'écart courante ($\varepsilon$) en fonction de la valeur de tension mesurée, et en fonction d'une valeur de tension théorique ($U'_{Smod}$) estimée à partir d'une modélisation du circuit de mesure, ladite modélisation étant fonction d'une valeur de capacité de l'élément capacitif,
   (c) calculer une valeur d'écart moyenné, à partir de la valeur d'écart courante et de valeurs d'écart précédentes,
   (d) estimer une valeur de résistance d'isolement actualisée ($R_{isol}$) en fonction de ladite valeur d'écart moyenné.

2. Procédé selon la revendication 1, dans lequel
   les étapes (a), (b), (c) et (d) sont réitérées régulièrement, et
   la valeur de résistance d'isolation actualisée au cours d'une itération courante ($R_{isol}$) est utilisée à l'itération suivante pour la modélisation du circuit de mesure.

3. Procédé selon l'une quelconque des revendications 1 ou 2, dans lequel, au cours de l'étape (b) la valeur d'écart courante ($\varepsilon$) est calculée en prenant la différence entre la valeur de tension mesurée ($U'_{Smes}$) et la valeur de tension théorique ($U'_{Smod}$), le signe de ladite différence étant fonction d'une valeur d'un signal d'entrée du circuit de mesure ($U_e$).

4. Procédé selon l'une quelconque des revendications 1 à 3, dans lequel, au cours de l'étape (c), la valeur d'écart moyenné est obtenue en ajoutant à la valeur d'écart courante ($\varepsilon$) une valeur d'écart moyenné précédente.

5. Procédé selon l'une quelconque des revendications 1 à 4, dans lequel l'étape (d) d'estimation de la valeur de résistance d'isolement actualisée ($R_{isol}$) est fonction d'une combinaison linéaire de la valeur d'écart courante ($\varepsilon$) et de la valeur d'écart moyenné calculée à l'étape (c).

6. Procédé selon la revendication 5, dans lequel, au cours de l'étape (d), la valeur de résistance d'isolement actualisée est estimée suivant la formule :

$$R_{isol}(n) = K_{variable}\left[R_{isol}(n-1)\right]\left(K_p\,\varepsilon + K_i\int\varepsilon\right)$$

   dans lequel n correspond à l'itération courante, (n-1) correspondant à l'itération immédiatement précédente,
   $R_{isol}(n)$ représente la valeur de résistance d'isolement actualisée au cours de l'itération courante,
   $R_{isol}(n-1)$ représente une valeur précédente de résistance d'isolement,
   $\varepsilon$ représente la valeur d'écart courante,
   $K_i$ et $K_p$ représentent des constantes prédéterminées, et
   $K_{variable}$ représente une valeur de paramètre choisie en fonction de de la valeur précédente de résistance d'isolement.

7. Procédé selon l'une quelconque des revendications précédentes, comprenant en outre

   (e) selon la valeur de résistance d'isolement actualisée à l'étape (d), générer un signal d'alarme ($S_{alarm}$) pour prévenir de la détection d'un défaut d'isolement.

8.  Dispositif d'estimation (10) de la résistance d'isolement entre un point d'un circuit haute-tension comprenant une batterie haute tension (2) de véhicule automobile et la masse (M) dudit véhicule, comprenant :

    des moyens de réception pour recevoir une valeur de tension mesurée aux bornes d'un circuit de mesure, ledit circuit de mesure comprenant un élément capacitif raccordé à la batterie,
    une mémoire pour stocker une modélisation du circuit de mesure, ladite modélisation étant fonction d'une valeur de capacité de l'élément capacitif, et
    des moyens de traitement agencés pour calculer une valeur d'écart courante en fonction de la valeur de tension mesurée et en fonction d'une valeur de tension théorique estimée à partir de la modélisation du circuit de mesure, pour calculer une valeur d'écart moyenné à partir de la valeur d'écart courante et d'une pluralité de valeurs d'écart précédentes, et pour estimer une valeur de résistance d'isolement actualisée en fonction de ladite valeur d'écart moyenné.

9.  Système d'estimation (10) de la résistance d'isolement entre un point d'un circuit haute-tension comprenant une batterie haute tension (2) de véhicule automobile et la masse (M) dudit véhicule, comprenant
    un circuit de mesure (3) comprenant un composant capacitif raccordé électriquement à la batterie, et
    un dispositif d'estimation selon la revendication 8, ce dispositif étant raccordé électriquement à une entrée (30) du circuit de mesure, et à une borne de mesure (32) du circuit de mesure.

10. Système selon la revendication 9, dans lequel le circuit de mesure (3) comprend
    une résistance d'entrée (R) dont une borne est raccordée électriquement à l'entrée (30) du circuit de mesure, et
    une partie de filtrage passe-bas comprenant un élément résistif ($R_f$) et un élément capacitif ($C_f$).

11. Véhicule automobile, comprenant une batterie (2) apte à faire rouler les roues avant et/ou les roues arrière du véhicule, et un système d'estimation (1) selon l'une des revendications 9 ou 10.


**Patentansprüche**

1.  Verfahren zum Schätzen des Isolationswiderstands zwischen einem Punkt eines Hochspannungskreises umfassend eine Kraftfahrzeug-Hochspannungsbatterie und der Masse des Fahrzeugs, umfassend:

    (a) das Messen eines Spannungswerts ($U'_{Smes}$) an den Klemmen eines Messkreises, wobei der Messkreis ein an die Batterie angeschlossenes kapazitives Element umfasst,
    (b) das Berechnen eines laufenden Abweichungswerts ($\varepsilon$) entsprechend dem gemessenen Spannungswert und entsprechend eines aus einer Modellierung des Messkreises geschätzten theoretischen Spannungswerts ($U'_{Smod}$), wobei die Modellierung von einem Kapazitätswert des kapazitiven Elements abhängt,
    (c) das Berechnen eines gemittelten Abweichungswerts aus dem laufenden Abweichungswert und vorhergehenden Abweichungswerten,
    (d) das Schätzen eines aktualisierten Isolationswiderstandswerts ($R_{isol}$) entsprechend dem gemittelten Abweichungswert.

2.  Verfahren nach Anspruch 1, wobei:

    die Schritte (a), (b), (c) und (d) regelmäßig wiederholt werden, und
    der im Laufe einer laufenden Wiederholung aktualisierte Isolationswiderstandswert ($R_{isol}$) in der folgenden Wiederholung zur Modellierung des Messkreises verwendet wird.

3.  Verfahren nach Anspruch 1 oder 2, wobei im Laufe des Schritts (b) der laufende Abweichungswert ($\varepsilon$) unter Verwendung der Differenz zwischen dem gemessenen Spannungswert ($U'_{Smes}$) und dem theoretischen Spannungswert ($U'_{Smod}$) berechnet wird, wobei das Vorzeichen der Differenz von einem Wert eines Eingangssignals des Messkreises ($U_e$) abhängt.

4.  Verfahren nach einem der Ansprüche 1 bis 3, wobei im Laufe des Schritts (c) der gemittelte Abweichungswert durch Hinzufügen eines vorhergehenden gemittelten Abweichungswerts zum laufenden Abweichungswert ($\varepsilon$) ermittelt wird.

5.  Verfahren nach einem der Ansprüche 1 bis 4, wobei der Schritt (d) zum Schätzen des aktualisierten Isolationswi-

derstandswerts ($R_{isol}$) von einer Linearkombination des laufenden Abweichungswerts ($\varepsilon$) und des in Schritt (c) berechneten gemittelten Abweichungswerts abhängt.

**6.** Verfahren nach Anspruch 5, wobei im Laufe des Schritts (d) der aktualisierte Isolationswiderstandswert gemäß der Formel geschätzt wird:

$$R_{isol}(n) = K_{\mathrm{var}iable}\left[R_{isol}(n-1)\right]\left(K_p \varepsilon + K_i \int \varepsilon\right)$$

wobei n der laufenden Wiederholung entspricht, (n-1) der unmittelbar vorhergehenden Wiederholung entspricht, $R_{isol}(n)$ den im Laufe der laufenden Wiederholung aktualisierten Isolationswiderstandswert darstellt, $R_{isol}(n-1)$ einen vorhergehenden Isolationswiderstandswert darstellt,
$\varepsilon$ den laufenden Abweichungswert darstellt,
$K_i$ und $K_p$ vorgegebene Konstanten darstellen, und
$K_{variable}$ einen entsprechend dem vorhergehenden Isolationswiderstandswert gewählten Parameterwert darstellt.

**7.** Verfahren nach einem der vorhergehenden Ansprüche, umfassend ferner

(e) gemäß dem in Schritt (d) aktualisierten Isolationswiderstandswert das Erzeugen eines Alarmsignals ($S_{alarm}$) zum Melden des Feststellens eines Isolationsfehlers.

**8.** Vorrichtung zum Schätzen (10) des Isolationswiderstands zwischen einem Punkt eines Hochspannungskreises umfassend eine Kraftfahrzeug-Hochspannungsbatterie (2) und der Masse (M) des Fahrzeugs, umfassend:

Empfangsmittel zum Empfangen eines an den Klemmen eines Messkreises gemessenen Spannungswerts, wobei der Messkreis ein an die Batterie angeschlossenes kapazitives Element umfasst,
einen Speicher zum Speichern einer Modellierung des Messkreises, wobei die Modellierung von einem Kapazitätswert des kapazitiven Elements abhängt, und
zum Berechnen eines laufenden Abweichungswerts entsprechend dem gemessenen Spannungswert und entsprechend einem mit der Modellierung des Messkreises geschätzten theoretischen Spannungswert ausgebildete Verarbeitungsmittel zum Berechnen eines gemittelten Abweichungswerts aus dem laufenden Abweichungswert und einer Vielzahl von vorhergehenden Abweichungswerten und zum Schätzen eines aktualisierten Isolationswiderstandswerts entsprechend dem gemittelten Abweichungswert.

**9.** System zum Schätzen (10) des Isolationswiderstands zwischen einem Punkt eines Hochspannungskreises umfassend eine Kraftfahrzeug-Hochspannungsbatterie (2) und der Masse (M) des Fahrzeugs, umfassend
einen Messkreis (3) umfassend eine elektrisch an die Batterie angeschlossene kapazitive Komponente, und
eine Schätzvorrichtung nach Anspruch 8, wobei die Vorrichtung elektrisch an einen Eingang (30) des Messkreises und an eine Messklemme (32) des Messkreises angeschlossen ist.

**10.** System nach Anspruch 9, wobei der Messkreis (3) umfasst
einen Eingangswiderstand (R), von dem eine Klemme elektrisch am Eingang (30) des Messkreises angeschlossen ist, und
einen Tiefpassfilterteil umfassend ein Widerstandselement ($R_f$) und ein kapazitives Element ($C_f$).

**11.** Kraftfahrzeug umfassend eine zum Bewegen der Vorderräder und/oder Hinterräder des Fahrzeugs ausgebildete Batterie (2) und ein System zum Schätzen (1) nach Anspruch 9 oder 10.

**Claims**

**1.** Method for estimating the insulation resistance between a point of a high-voltage circuit including a high-voltage motor vehicle battery and the earth of said vehicle, which includes:

(a) measuring a voltage value ($U'_{Smes}$) at the terminals of a measurement circuit, said measurement circuit comprising a capacitive element connected to the battery,

(b) calculating a standard deviation value ($\varepsilon$) based on the measured voltage value, and based on a theoretical voltage value ($U'_{Smod}$) estimated from a model of the measurement circuit, said model being a function of a capacitance value of the capacitive element,

(c) calculating an averaged deviation value from the standard deviation value and previous deviation values,

(d) estimating an updated insulation resistance value ($R_{isol}$) in accordance with said averaged deviation value.

2. Method according to Claim 1, wherein

the steps (a), (b), (c) and (d) are regularly reiterated, and

the insulation resistance value updated during a standard iteration ($R_{isol}$) is used in the next iteration for the model of the measurement circuit.

3. Method according to either one of Claims 1 and 2, wherein, during step (b) the standard deviation ($\varepsilon$) is calculated by taking the difference between the measured voltage value ($U'_{Smes}$) and the theoretical voltage value ($U'_{Smod}$), the sign of said difference being a function of an input signal value of the measurement circuit ($U_e$) .

4. Method according to any one of Claims 1 to 3, wherein, during step (c), the averaged deviation value is obtained by adding a previous averaged deviation value to the standard deviation value ($\varepsilon$).

5. Method according to any one of Claims 1 to 4, wherein step (d) for estimating the updated insulation resistance value ($R_{isol}$) is a function of a linear combination of the standard deviation value ($\varepsilon$) and the averaged deviation value calculated in step (c).

6. Method according to Claim 5, wherein, during step (d), the updated insulation resistance value is estimated according to the formula:

$$R_{isol}(n) = K_{\mathrm{var}iable}\big[R_{isol}(n-1)\big]\Big(K_p\varepsilon + K_i\int\varepsilon\Big)$$

wherein n corresponds to the standard iteration (n-1) corresponding to the immediately preceding iteration,

$R_{isol}$ (n) represents the insulation resistance value updated during the standard iteration,

$R_{isol}$ (n-1) represents a previous insulation resistance value,

$\varepsilon$ represents the standard deviation value,

$K_i$ and $K_p$ represent predetermined constants, and

$K_{variable}$ represents a parameter value selected as a function of the previous insulation resistance value.

7. Method according to any one of the preceding claims, further comprising

(e) according to the insulation resistance value updated in step (d), generating an alarm signal ($S_{alarm}$) to prevent detection of an insulation fault.

8. Device (10) for estimating the insulation resistance between a point of a high-voltage circuit including a high-voltage motor vehicle battery (2) and the earth (M) of said vehicle, which includes:

receiving means to receive a voltage value measured at the terminals of a measurement circuit, said measurement circuit comprising a capacitive element connected to the battery,

a memory for storing a model of the measurement circuit, said model being a function of a capacitance value of the capacitive element, and

processing means arranged to calculate a standard deviation value based on the measured voltage value and based on a theoretical voltage value estimated from the model of the measurement circuit, in order to calculate a deviation value averaged from the standard deviation value and a plurality of previous deviation values, and to estimate an insulation resistance value updated according to said averaged deviation value.

9. System (10) for estimating the insulation resistance between a point of a high-voltage circuit including a high-voltage motor vehicle battery (2) and the earth (M) of said vehicle, which includes

a measurement circuit (3) comprising a capacitive component electrically connected to the battery, and

an estimation device according to Claim 8, this device being electrically connected to an input (30) of the measurement circuit, and to a measurement terminal (32) of the measurement circuit.

10. System according to Claim 9, wherein the measurement circuit (3) comprises
an input resistor (R), one terminal of which is electrically connected to the input (30) of the measurement circuit, and
a low-pass filtering part comprising a resistive element ($R_f$) and a capacitive element ($C_f$) .

11. Motor vehicle, comprising a battery (2) capable of rotating the front and/or rear wheels of the vehicle, and an estimation system (1) according to either of Claims 9 and 10.

**Fig.1**

**Fig.2**

## Fig.3A

## Fig.3B

**EP 3 077 834 B1**

## RÉFÉRENCES CITÉES DANS LA DESCRIPTION

**Documents brevets cités dans la description**

- JP 3783633 B

- FR 2987133